# EUROPÄISCHE PATENTSCHRIFT

(11) **EP 3 428 668 B1**
(45) Veröffentlichungstag und Bekanntmachung des Hinweises auf die Patenterteilung: **27.07.2022**
(21) Anmeldenummer: 18186092.5
(22) Anmeldetag: 30.06.2015
(51) Int. Cl.: G01R 31/34, H02P 29/02, G01R 19/165, H02P 29/024, H02M 1/32

(54) **VERFAHREN ZUR ERLANGUNG EINES HINWEISES, INSBESONDERE EINES ANFANGSHINWEISES AUF EINE MÖGLICHE FEHLERHAFTE LASTBEDINGUNG EINES MEHRPHASIGEN ELEKTROMOTORS**
METHOD FOR OBTAINING AN INDICATION, IN PARTICULAR AN INITIAL INDICATION OF A POSSIBLE FAULTY LOAD CONDITION OF A POLYPHASE ELECTRIC MOTOR
PROCÉDÉ D'OBTENTION D'UNE INSTRUCTION, EN PARTICULIER D'UNE INSTRUCTION INITIALE SUR UNE CONDITION DE CHARGE POSSIBLE ERRONÉE D'UN MOTEUR ÉLECTRIQUE MULTIPHASE

(30) Priorität: 30.06.2014 DE 102014212572; 30.06.2014 DE 102014212586; 30.06.2014 DE 102014212626
(43) Veröffentlichungstag der Anmeldung: 16.01.2019
(62) Teilanmeldung aus: 15733434.3
(73) Patentinhaber: Elmos Semiconductor SE, 44227 Dortmund (DE)
(72) Erfinder: Hartzsch, Jörg, 44227 Dortmund (DE)
(74) Vertreter: dompatent von Kreisler Selting Werner - Partnerschaft von Patent- und Rechtsanwälten mbB

(56) Entgegenhaltungen:
- EP-A2- 1 136 828
- DE-A1-102008 052 933
- DE-A1-102011 003 897
- DE-A1-102011 004 911
- JOHNSON J P ET AL: "Review of sensorless methods for brushless DC", CONFERENCE RECORD OF THE 1999 IEEE INDUSTRY APPLICATIONS CONFERENCE. THIRTY-FORTH IAS ANNUAL MEETING (CAT. NO.99CH36370), IEEE, IEEE PISCATAWAY, NJ, USA, Bd. 1, 3. Oktober 1999 (1999-10-03), Seiten 143-150, XP010355155, DOI: 10.1109/IAS.1999.799944 ISBN: 978-0-7803-5589-7

## Beschreibung

Die Erfindung betrifft ein Verfahren zur Erlangung eines Hinweises, insbesondere eines Anfangshinweises auf eine mögliche fehlerhafte Lastbedingung eines mehrphasigen Elektromotors.

Fehlerhafte Lastbedingungen bei Elektromotoren sind insbesondere dann kritisch, wenn Kurzschlüsse auftreten. Derartige Kurzschlüsse werden üblicherweise anhand der Spannungsabfälle über den Drain-Source-Strecken der internen oder externen Treiber-Transistoren der Ansteuereinheit erkannt, über die Elektromotore oder andere Lasten angesteuert werden. Diese Spannungsabfälle werden im Regelfall einzeln, d.h. pro Phase des Motors, bewertet. Wenn ein messtechnisch erfasster Strom höher als der größte in Betrieb zulässige Strom ist, deutet dies auf einen externen Kurzschluss von mindestens einer der Motoranschlussleitungen hin. Ein Nachteil bei der Detektion von Kurzschlüssen ist, dass insbesondere "weiche" Kurzschlüsse nach Masse nicht unbedingt erkannt werden können. Ein weiteres Problem besteht darin, dass der Überstrom bei relativ hochohmigen Kurzschlüssen oder bei Kurzschlüssen mit induktivem Beiwert des Kurzschlussstroms teilweise nicht außerhalb des größten, im Betrieb des Motors zulässigen Stroms liegt. Auch ist es bei induktiven Beiwerten und bei PWM-Ansteuerungen von Lasten, wie z.B. Elektromotoren, möglich, dass die Stromzunahme im Kurzschlussfall so langsam ist ("weicher" Kurzschluss), dass ein PWM-Zyklus vor Erreichen der Überstrom-Abschaltschwelle beendet ist. Die Leistungstransistoren aber können sich in derartigen Fällen dennoch derart stark aufheizen, dass es zu Schädigungen kommen kann, die so schnell auftreten, dass auch eine Übertemperaturerkennung wegen ihres Zeitverzuges keinen ausreichenden Schutz bietet.

Verfahren zur Fehlerstromdetektion bei Elektromotoren mit elektrischer Kommutierung sind z. B. aus DE-A-102 16 986, US-B-8 054 026, EP-A-2 164 169 und EP-A-2 116 857 bekannt, und zwar unter Zugrundelegung eines Vergleichs von Mustern aus wiederholt auftretenden elektrischen Parametern des Elektromotors mit für dessen fehlerfreien Betrieb geltenden Erwartungswerten. Aus EP-A- 1 136 828 ist ein Verfahren zur Messung der Stromaufnahme eines mit einer Steuerelektronik geregelten Elektromotors bekannt.

Aufgabe der Erfindung ist es daher, eine Kurzschlusserkennung zu schaffen, die in der Lage ist, einen Kurzschluss zuverlässig aufzudecken und somit die Transistoren vor einer Schädigung zu schützen, was darauf hinausläuft, dass ein Brand der Elektronik verhindert werden kann.

Zur Lösung dieser Aufgabe wird mit der Erfindung ein Verfahren nach Anspruch 1 vorgeschlagen. Einzelne Ausgestaltungen der Erfindung sind Gegenstand der Unteransprüche 2 bis 15.

Das Verfahren nach der Erfindung dient der Erlangung eines Hinweises, insbesondere eines Anfangshinweises auf eine mögliche fehlerhafte Lastbedingung eines mehrphasigen Elektromotors mit elektrischer Kommutierung (z.B.: BLDC-, EC-, SR- oder Steppermotoren) mit einer elektronischen Ansteuerung, die pro Motorphase einen Highside-Schalter und einen Lowside-Schalter aufweist, wobei die Highside- und die Lowside-Schalter der Motorphasen zyklisch ein- und ausgeschaltet werden, und zwar gemäß einem Schaltschemas, das zyklisch wiederkehrende Zeitpunkte aufweist, in denen für zu mindestens eine Motorphase sowohl der Highside- als auch der Lowside-Schalter für ein Ausschaltintervall hochohmig geschaltet, d.h. ausgeschaltet sind, wobei bei fehlerfreier Lastbedingung zumindest zu Beginn einzelner Ausschaltintervalle oder auch über mehrere Ausschaltintervalle hinweg noch für eine gewisse Rezirkulationszeitspanne, die gleich einem für einen fehlerfreien Betrieb des Motors entsprechendem Erwartungswert ist, ein Strom fließt, wobei bei dem Verfahren
- mit Beginn eines im Schaltschema vorgegebenen Ausschaltintervalls eine Zeitmesseinheit gestartet und die Rezirkulationszeitspanne gemessen wird, bis zu der in der abgeschalteten Motorphase noch ein Strom einer Größe fließt, deren vorzeichenunabhängiger Betrag größer ist als ein vorgegebener Schwellwert,
- wobei diese Zeitmessung, sofern die Rezirkulationszeitspanne nicht während des besagten Ausschaltintervalls beendet wird, dann im zumindest nächsten Ausschaltintervall weitergeführt wird, bis die Rezirkulationszeitspanne beendet ist,
- wobei dieser Vorgang für Ausschaltintervalle nach vorheriger Highside-Schalter-Aktivierung und/oder nach vorheriger Lowside-Schalter-Aktivierung jeder Phase des Motors wiederholt wird,
- wobei die gemessenen Rezirkulationszeitspannen für die verschiedenen Phasen des Motors untereinander und/oder für jeweils eine Phase des Motors in sequentieller Abfolge miteinander und/oder mit dem Erwartungswert oder einem Erwartungswert verglichen werden und
- wobei eine Abweichung von dem jeweiligen Erwartungswert als ein Hinweis, insbesondere Anfangshinweis auf einen Fehlerstrom gewertet wird.

Nach der Erfindung ist also ein Schaltschema für die Bestromung eines mehrphasigen Elektromotors vorgesehen, das pro Motorphase hochohmig geschaltete Highside- und Lowside-Schalter vorsieht. Beide dieser Schalter einer Motorphase sind also kurzzeitig ausgeschaltet. Dadurch fließt, bedingt durch die induktive Last, die der Elektromotor darstellt, ein Strom, dessen Abklingen und insbesondere dessen Abklingzeit Aussagen darüber zulässt, ob der Elektromotor augenblicklich unter fehlerhaften Lastbedingungen läuft. Dazu werden erfindungsgemäß die Rezirkulationszeitspannen pro Motorphase oder aber die Rezirkulationszeitspannen von Phase zu Phase des Motors miteinander vergleichen bzw. ins Verhältnis zueinander gesetzt. Sofern die naturgemäß vorhandenen Schwankungen der Rezirkulationszeitspannen innerhalb von Erwartungswertebereichen liegen, ist davon auszugehen, dass der Elektromotor fehlerfrei arbeitet. Bei Veränderungen der Rezirkulationszeitspannen kann dies, gegebenenfalls nach weiteren Prozeduren, als Anfangshinweis für eine möglicherweise fehlerhafte Lastbedingung des Motors angesehen werden. In welcher Form auf einen derartig erkannten ersten Hinweis reagiert wird (beispielsweise Abschalten des Elektromotors, Überführen des Elektromotors in einen anderen Betriebszustand zum Schutze des Motors vor einer drohenden Zerstörung etc.) ist grundsätzlich nicht Gegenstand der Erfindung. Auch ist es für die Erfindung grundsätzlich nur von untergeordneter Bedeutung, nach welcher Zeitspanne ab dem ersten Erkennen eines Hinweises auf eine möglicherweise vorliegende fehlerhafte Lastbedingung in welcher Form reagiert wird.

Durch die Bildung der Verhältnisse der motorphasenübergreifend aufeinanderfolgenden Rezirkulationszeitspannen oder aber der pro Phase des Motors aufeinanderfolgenden Rezirkulationszeitspannen werden Werte berechnet, die mit einem Erwartungswert bzw. mit einem Erwartungswertbereich vergleichen werden. Sofern die berechneten Werte innerhalb eines Erwartungswertbereichs liegen, wird nicht davon ausgegangen, dass eine fehlerbehaftete Lastbedingung vorliegen könnte.

Die Erfindung ist insbesondere vor dem Hintergrund zu sehen, dass für die Ansteuerung mehrphasiger Elektromotoren oder anderer induktiver Lasten in zunehmendem Maße niederohmige Leistungstransistoren eingesetzt werden. Diese Leistungstransistoren sind derart preisgünstig herstellbar, dass ihre Gesamtkosten für das Gesamtsystem geringer sind als wenn man z.B. mit einem Kühlkörper zur Kühlung konventioneller Leistungstreiber arbeiten würde, die einen höheren R_{SDON} aufweisen. Ein weiterer Vorteil des Einsatzes moderner niederohmiger Leistungstransistoren ist in dem vereinfachten Verbau der Elektronik auf Grund der geringeren Verlustleistung dieser Leistungstransistoren zu sehen. Außerdem reduziert sich in der Gesamtenergiebilanz betrachtet der CO₂-Ausstoß. Allerdings sind durch die niederohmigen Leistungstransistoren die Spannungsabfälle im Kurzschlussfall wegen des niedrigen R_{SDON} derart klein, dass ein Kurzschlussfall mit bisherigen Mitteln nicht mehr sicher detektiert werden kann. Man arbeitet daher mit deutlich empfindlicheren Kurzschlussschwellen, um den geänderten Anforderungen infolge niederohmiger Leistungstransistoren begegnen zu können. Hierbei handelt es sich allerdings um Lösungen des Problems, die nicht alle Kurzschlussfälle zu erkennen vermögen. Insbesondere im Hinblick auf BLDC- und DC-Brückentreiber-ICs sowie Steppermotor-Treiber-ICs hat der erfindungsgemäße Ansatz klare Vorteile, indem er sich auf Grund der großen Nachfrage derartiger Treiber-ICs schnell durchsetzen würde.

Die Erwartungswerte bzw. Erwartungswertbereiche werden zweckmäßigerweise empirisch festgelegt. Hierbei ist denkbar,
- dass die Erwartungswerte für maximal zulässige Abweichungen, bei denen noch keine fehlerhafte Lastbedingung erkannt werden soll, an einem oder mehreren vorgealterten Referenzsystemen mit fehlerfreiem Lastzustand angelernt, also die typischen Werte ermittelt und mit wählbaren zusätzlichen zulässigen Toleranzen versehen in der Ansteuereinheit als maximal zulässiger Erwartungswertbereich abgelegt werden, und/oder
- dass die Erwartungswerte für maximal zulässige Abweichungen bei denen noch keine fehlerhafte Lastbedingung erkannt werden soll, an jedem Motorsystem für sich nach der Produktion mit fehlerfreiem Lastzustand angelernt, also die typischen Werte ermittelt und mit wählbaren zusätzlichen zulässigen Toleranzen versehen in der Ansteuereinheit als maximal zulässiger Erwartungswertbereich abgelegt werden, und/oder
- dass die Erwartungswerte für maximal zulässige Abweichungen bei denen noch keine fehlerhafte Lastbedingung erkannt werden soll, im Laufe der Lebenszeit des Motors mit höheren Toleranzen versehen werden, und/oder
- dass die detektierte fehlerhafte Lastbedingung durch ein Abweichen des Kommutierungswinkels vom Zielbereich entsteht und dass die Ansteuereinheit den Fehler durch Anpassung zumindest eines der beiden Ansteuerparameter Amplitude und Phase kompensiert.

In vorteilhafter Weiterbildung der Erfindung kann vorgesehen sein, dass aus der Art der Abweichungen von den Erwartungswerten für die einzelnen Motorphasen untereinander auf die Art des/der fehlerhaften Lastbedingungen wie Nebenschluss Motorphase gegen Motorphase, Nebenschluss Motorphase gegen Ground, Nebenschluss Motorphase gegen Versorgungsspannung, zu hochohmiger Motorphasenanschluss (evtl. durch Kontaktierungsproblem in Steckern), Wackelkontakt einer Motorphase, Fehlerhafte Treiberwiderstände einzelner Highside- oder Lowside-Treiber (ggf. nur unter bestimmten Lastzuständen) und/oder auch für jede einzelne Motorphase in sequentieller Abfolge auf die fehlerhaften Lastbedingungen wie Wackelkontakt, mechanische Fehler, Lagerspiel, Getriebefehler, mechanische Fehler in der Applikation, wobei die Häufigkeit der sequentiell auftretenden Abweichungen Aussage geben kann über den genauen Fehlerort , geschlossen wird.

Zwecks Klassifizieren der Abweichung des betreffenden Parameters von dem entsprechenden Erwartungswert oder -bereich können Verfahren zur statistischen Mustererkennung Anwendung finden, mit denen Betriebszustände des elektrischen (Schritt-)Motors klassifizierbar sind, um definierte Maßnahmen zur Minimierung der Auswirkung von Fehlfunktionen und zur Prognostizierung der zukünftigen Auswirkungen einer Fehlfunktion auf den Motor ergreifen zu können. Die Prognose kann dabei in Form zukünftiger möglicher Betriebszustände erfolgen, denen Wahrscheinlichkeiten und/oder Bewertungszahlen (z.B. Auswirkungsbewertungen) zugeordnet sind.

Hierbei können ein oder mehrere der nachfolgend aufgelisteten Verarbeitungsschritte durchgeführt werden:
a) Bilden eines Feature-Vektors aus mehreren Werten der Abweichungen, die gleichzeitig und/oder sequenziell festgestellt werden wobei der Feature-Vektor auf einfache und höhere Ableitungen und/oder einfache und höhere Integrale dieser Werte und/oder andere aus diesen Werten abgeleitete Größen sowie weitere Größen aus anderen Sensorsystemen umfassen kann.
b) Multiplikation eines Feature-Vektors mit einer Lineardiskriminanzanalyse-(LDA-)Matrix zu einem modifizierten Feature-Vektor zur Steigerung der Selektivität.
c) Vergleich des modifizierten Feature-Vektors mit prototypischen Vektoren, d.h. den Betriebszustandsprototypen, die insbesondere in einer Prototypendatenbank abgelegt sind, wobei das Ergebnis des Vergleiches ein binärer und/oder digitaler und/oder analoger Abstandswert zwischen dem modifizierten Feature-Vektor und dem jeweiligen prototypischen Vektor je bewertetem prototypischen Vektor ist.
d) Selektion mindestens eines Betriebszustandsprototyps der besagten Datenbank aufgrund eines Abstandswertes, wobei insbesondere der Betriebszustandsprototypen mit dem kleinsten Abstandswert und/oder der Betriebszustand mit der schwersten Auswirkung und/oder mit der schwersten Auswirkungsbewertung selektiert wird.
e) Ausgabe zumindest des selektierten Betriebszustandsprototypen.
f) Gegebenenfalls Ausgabe zumindest des Abstandswertes der dem Feature-Vektor relativ zum selektierten Betriebszustandsprototypen zugeordnet ist und/oder eines daraus abgeleiteten Wertes.
g) Gegebenenfalls Ausgabe weiterer selektierte Betriebszustandsprototypen und zugehöriger Abstandswerte und/oder daraus abgeleiteter Werte zur Ausgabe einer Hypothesenliste, die typischerweise auch den selektierten Betriebszustandsprototypen und dessen Abstandswert umfasst.
h) Gegebenenfalls Ermittlung der wahrscheinlichsten Kette von Betriebszustandsprototypen und Prognose mindestens eines folgenden prognostizierten Betriebszustandes oder einer prognostizierten Betriebszustandssequenz.
i) Gegebenenfalls Einleitung von Maßnahmen auf Grund des selektierten Betriebszustandes und/oder der ermittelten Hypothesenliste und/oder des prognostizierten Betriebszustandes oder der prognostizierten Betriebszustandssequenz.

Alternativ zu den an sich bekannten Grundverfahren der statistischen Mustererkennung können zur Verarbeitung der Abweichungen des betreffenden Parameters von dem diesem zugeordneten Erwartungswert oder -bereich neuronale Netze und/oder Petrinetze und/oder Fuzzy-Logik und/oder ein Viterbi-Algorithmus eingesetzt werden.

In vorteilhafter Weiterbildung der Erfindung kann ferner vorgesehen sein, dass anstelle der Größe eines Stroms ein die Größe des Stroms repräsentierender elektrischer Parameter gemessen wird, und zwar z.B. ein Spannungsabfall über einem elektrischen/elektronischen Bauteil, insbesondere über einem Shunt-Widerstand oder einem Transistor, bei dem es sich insbesondere um einen Highside- und/oder einen Lowside-Schalter handelt.

Ferner kann es zweckmäßig sein, wenn die Zeitmessung in der hochohmigen Motorphase durch einen Komparator beendet wird, wenn die Spannung der Motorphase eine eingestellte Komparatorschwelle über- oder unterschreitet.

Von Vorteil kann es sein, wenn auf die eigentlich hochohmige Motorphase ein vorgegebener, dem Rezirkulationsstrom entgegengesetzter Prüfstrom aufgeschaltet wird, demzufolge der Spannungs-Wechsel am Motorphasenanschluss bei Reduktion des Rezirkulationsstromes auf den eingestellten Prüfstrom erfolgt.

Vorteilhaft kann es sein, wenn die Zeitmesseinheit linear, also mit gleichbleibender Zählgeschwindigkeit arbeitet.

Ferner kann es von Vorteil sein, wenn die Zeitmesseinheit logarithmisch arbeitet.

In vorteilhafter Weiterbildung der Erfindung kann vorgesehen sein, dass die Zeitmessung zwischen den einzelnen Intervallen des Hochohmig-Schaltens angehalten wird.

In vorteilhafter Weiterbildung der Erfindung kann ferner vorgesehen sein, dass die Zeitmessung zwischen den einzelnen Intervallen des Hochohmig-Schaltens weiterläuft.

Vorteilhaft kann es sein, wenn anstelle der beschriebenen exakten Zeitmessung lediglich zu einem festen Zeitpunkt nach einem Hochohmig-Schalten eine Überprüfung auf Über- oder Unterschreitung der vorgebbaren Komparatorschwelle erfolgt und demzufolge die Zeitmessung in der dadurch entstehenden Auflösung (Anzahl von PWM-Zyklen mit Hochohmig-Schalten) erfolgt.

Ferner kann es vorteilhaft sein, wenn anstelle der Zeitspanne zwischen den besagten Mess-Start-Zeitpunkten im Schaltschema und der Einnahme der Stromschwellwerte, die Zeitspannen zwischen den einzelnen Über- und/oder Unterschreitungen der Komparator-Schwellwerte gemessen und die Zeiten der einzelnen Motorphasen untereinander und/oder jeder Motorphase für sich in zeitlicher Abfolge verglichen oder mit einem für den fehlerfreien Betrieb des Motors geltenden Erwartungswert verglichen werden, wobei eine Abweichung der Größe der aktuellen Zeitspannen untereinander und/oder von dem Erwartungswert als ein Hinweis, insbesondere Anfangshinweis auf einen Fehlerstrom gewertet wird.

Gegenüber dem Stand der Technik ergibt sich unter Verwendung des erfindungsgemäßen Verfahrens eine höhere Erkennungssicherheit auf fehlerhafte Lastbedingungen durch verbesserte Nutzsignale und eine verbesserte Performance des Detektionsverfahrens. Die Erkennungsschwelle für das Vorliegen einer fehlerhaften Lastbedingung (z.B. Kurzschluss) ist nicht mehr abhängig von der Größe des maximal im Betrieb zulässigen Stroms. Außerdem ist eine günstige Implementierung des erfindungsgemäßen Verfahrens möglich.

Die Erfindung ist insbesondere vor dem Hintergrund zu sehen, dass für die Ansteuerung mehrphasiger Elektromotoren oder anderer induktiver Lasten in zunehmendem Maße niederohmige Leistungstransistoren eingesetzt werden. Diese Leistungstransistoren sind derart preisgünstig herstellbar, dass ihre Gesamtkosten für das Gesamtsystem geringer sind als wenn man z.B. mit einem Kühlkörper zur Kühlung konventioneller Leistungstreiber arbeiten würde, die einen höheren R_{SDON} aufweisen. Ein weiterer Vorteil des Einsatzes moderner niederohmiger Leistungstransistoren ist in dem vereinfachten Verbau der Elektronik auf Grund der geringeren Verlustleistung dieser Leistungstransistoren zu sehen. Außerdem reduziert sich in der Gesamtenergiebilanz betrachtet der CO₂-Ausstoß. Allerdings sind durch die niederohmigen Leistungstransistoren die Spannungsabfälle im Kurzschlussfall wegen des niedrigen R_{SDON} derart klein, dass ein Kurzschlussfall mit bisherigen Mitteln nicht mehr sicher detektiert werden kann. Man arbeitet daher mit deutlich empfindlicheren Kurzschlussschwellen, um den geänderten Anforderungen infolge niederohmiger Leistungstransistoren begegnen zu können. Hierbei handelt es sich allerdings um Lösungen des Problems, die nicht alle Kurzschlussfälle zu erkennen vermögen. Insbesondere im Hinblick auf BLDC- und DC-Brückentreiber-ICs sowie Steppermotor-Treiber-ICs hat der erfindungsgemäße Ansatz klare Vorteile, indem er sich auf Grund der großen Nachfrage derartiger Treiber-ICs schnell durchsetzen würde.

Die Erfindung wird nachfolgend anhand von Ausführungsbeispielen sowie unter Bezugnahme auf die Zeichnung näher erläutert. Im Einzelnen zeigen dabei:
- Fig. 1: eine Beschaltungsoption für die Ansteuerung eines grundsätzlich beliebigen mehrphasigen (im Ausführungsbeispiel dreiphasigen) Elektromotors,
- Fig. 2: ein Beispiel für eine Block-Kommutierung eines beispielsweise dreiphasigen Motortyps (beispielsweise gemäß Fig. 1),
- Fig. 3: eine Beschaltungsoption für einen bipolaren elektrisch kommutierten Motor (z.B. Stepper-Motor) und
- Fig. 4: ein Beispiel für eine Block-Kommutierung eines bipolaren elektrisch kommutierten Motors (beispielsweise gemäß Fig. 3).

Kommen im Schaltschema einer mehrphasigen induktiven Last (z.B. mehrphasiger Elektromotor) Intervalle mit hochohmig geschalteten Endstufen vor oder ist man in der Lage, diese in ein Schaltschema einer mehrphasigen induktiven Last einzubauen, so kann mittels eines einfachen Komparators im hochohmig geschalteten Zustand eines Lastanschlusses der Zeitpunkt des Vorzeichenwechsels des Stroms nach dem Hochohmig-Schalten detektiert werden. In dem Fall, dass im Schaltschema üblicherweise keine hochohmig geschalteten Motorphasen vorkommen, sind diese gemäß dem erfindungsgemäßen Verfahren kurz vor der Stelle einzubauen, an der der Wert des betreffenden Stromes Null erreicht. Die erfindungsgemäß gemessene Rezirkulationszeit ist ein Maß für den in der induktiven Last (Motorwicklung) vorhandenen Strom zum Zeitpunkt des Hochohmig-Schaltens und auch für die Induktivität des Motoranschlusses. Hier kann man entweder die Zeitpunkte mit den durch die PWM-Ansteuerung vorgegebenen Vorgabewerten vergleichen oder aber bevorzugt die Zeiten zwischen Hochohmig-Schalten und Aktivierung des Komparators zu bestimmten PWM-Kombinationen vermessen und die Zeitmessungen der einzelnen Motorphasen miteinander vergleichen.

Weichen die Ergebnisse dieser Vergleiche von Erwartungswerten ab, so kann man anhand der Art der Abweichungen auf unterschiedliche Fehlstrom-Ursachen schließen. Asymmetrisch aufgebaute Motoren können dabei zu Erwartungswerten führen, die Asymmetrien enthalten.

Auch können sich die Erwartungswerte über mehrere elektrische Bewegungszyklen hinweg ändern, wenn z.B. ein mehrpoliger Motor mehrere elektrische Zyklen durchfahren muss, um eine mechanische Umdrehung durchzuführen. Hier kann es dann zu einem zyklischen Muster von Vergleichswerten (d.h. Erwartungswerten) kommen.

Ohne Fehlströme sollten sich die besagten Muster von Vergleichswerten einstellen. Bei Nebenschlüssen oder anderen Fehlern werden die Verhältnisse der Rezirkulationszeiten zueinander von den Erwartungswerten abweichen. Bei entsprechender Empfindlichkeit der Messeinrichtung können die oben beschriebenen Signale auch zur Kommutierung des Motors genutzt werden. Eine Realisierung kann zum großen Teil in kompakter Digitaltechnik erfolgen.

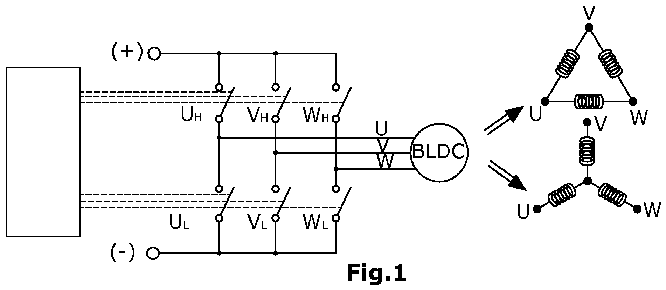

Fig. 1 zeigt ein Beispiel für die Beschaltung eines in diesem Ausführungsbeispiel dreiphasigen Elektromotors mit Hilfe einer Vollbrücke, die den drei Phasen U, V und W jeweils zugeordnete Highside-Schalter U_{H}, V_{H} und W_{H} sowie drei diesen Phasen jeweils zugeordnete Lowside-Schalter U_{L}, V_{L} und W_{L} aufweist. Der Elektromotor ist mit BLDC (brushless DC) bezeichnet und kann beispielsweise in Stern- oder Dreiecksbetrieb gefahren werden.

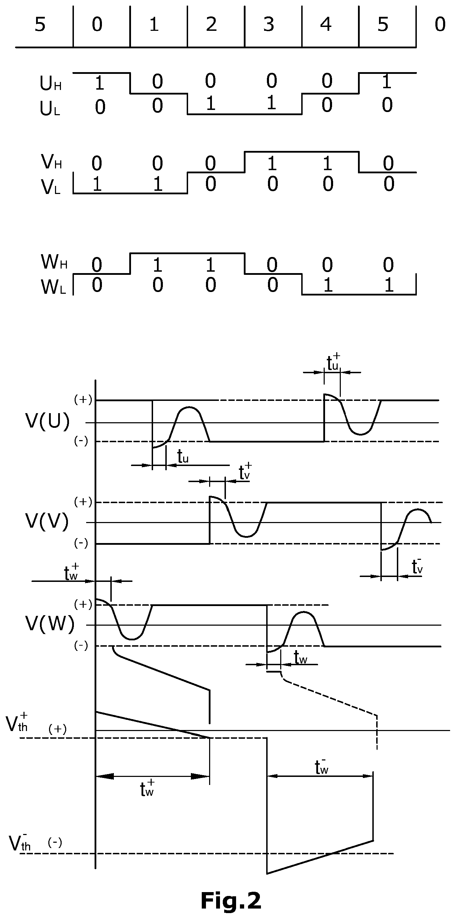

Eine mögliche Blockkommutierung für einen derartigen dreiphasigen Motor mit Beschaltung gemäß Fig. 1 ist in Fig. 2 gezeigt. Die einzelnen Abschnitte einer elektrischen 360°-Drehung sind mit 0 bis 5 bezeichnet. Die Ein- und Auszustände der Highside- und Lowside-Schalter U_{H}, U_{L}, V_{H}, V_{L}, W_{H}, und W_{L} sind in Fig. 2 mit 1 (für eingeschaltet) und 0 (für ausgeschaltet) dargestellt. Zu erkennen ist, dass das Schalt- bzw. Kommutierungsschema Zeitabschnitte aufweist, in denen einzelne Motorphasen hochohmig geschaltet sind.

Der Zeitverlauf der Spannungen an den drei Phasen des Motors ist bei V(U), V(V) und V(W) gezeigt. Die Transienten in den Spannungsverläufen an den Motorphasen sind vergrößert in den letzten beiden Diagrammen gezeigt. Die Transientenzeiten, also die Rezirkulationszeitspannen (tᵤ⁺, tᵤ, tᵥ⁺, tᵥ⁻, t_{w}⁺, t_{w}⁻ ) werden von Phase zu Phase des Motors bzw. phasenübergreifend, oder innerhalb einer Motorphase fortlaufend und/oder intermittierend und/oder sporadisch von Zeit zu Zeit miteinander verglichen werden. Durch diesen Vergleich der Rezirkulationszeitspannen kann auf Fehlerzustände des Motors geschlossen werden. Wiederholen sich die konstruktionsbedingt gegebenen Rezirkulationszeitspannenunterschiede zyklisch, so kann auf Asymmetrien des Elektromotors geschlossen werden. Plötzliche Änderungen oder andere Änderungen der Rezirkulationszeitspannen, die von dem zuvor beschriebenen Muster abweichen, lassen auf fehlerhafte Lastbedingungen schließen. Durch den erfindungsgemäß vorgesehenen Vergleich der Rezirkulationszeitspannen kann also ein erster Hinweis auf einen Fehlerzustand des Motors erlangt werden.

Neben der in Fig. 2 gezeigten Blockkommutierung lässt sich das erfindungsgemäße Verfahren aber auch bei Elektromotoren realisieren, die mit Sinus- oder Space-Vector-Kommutierung arbeiten. Bei diesen Kommutierungsschemata existieren üblicherweise keine hochohmigen Zustände, die ausreichend lang für eine Detektion der Rezirkulationszeitspanne wären. Es kann aber im Bereich des zu erwartenden Nulldurchgangs des Phasenstroms eine hochohmig geschaltete Motorphase eingeführt werden. Diese kann entweder eine feste Länge aufweisen oder sie wird bevorzugt nach Abschluss der Zeitmessung beendet.

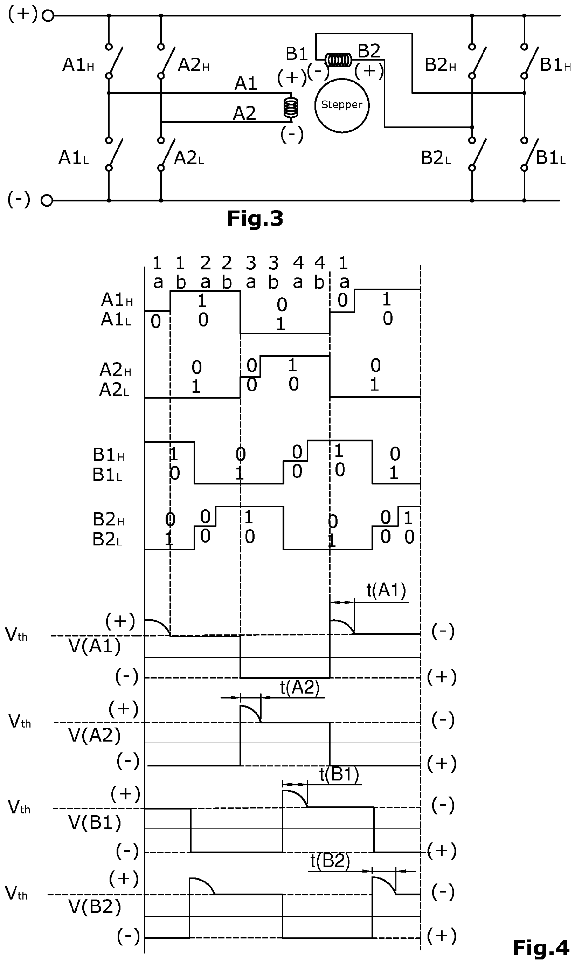

Fig. 3 zeigt die Beschaltung eines bipolaren elektrisch kommutierten Motors mit den Highside- und Lowside-Schaltern A1_{H}, A2_{H}, A1_{L}, A2_{L}, B1_{H}, B2_{H}, B1_{L} und B2_{L}. Ein entsprechend Kommutierungsschema für einen derartigen elektrisch kommutierten Motor ist beispielhaft in Fig. 14 angegeben. Auch hier ist zu erkennen, dass im Funktionsblock L Rezirkulationszeitspannen t(A1), t(A2), t(B1) und t(B2) miteinander verglichen werden. Dieser Vergleich kann motorphasenübergreifend oder aber innerhalb einer Motorphase bzw. jeder Motorphase erfolgen.

Eine bevorzugte Ausführungsvariante für die Ermittlung der Rezirkulationszeitspanne ist eine logarithmische Zeitmessung. Diese folgt einer einem Logarithmus angenäherten Funktion, und zwar in der Art, dass sich mit zunehmender Zählzeit die Geschwindigkeit des Zählers verringert. Das hat folgende Vorteile:
a) Es können kleine und große Zeiten mit der gleichen relativen Genauigkeit ermittelt werden. Eine unnötig hohe Genauigkeit bei großen Absolutzeitmessungen entfällt.
b) Die Anzahl auszuwertender Bits pro Messwert verringert sich drastisch.
c) Die Ermittlung von Zeitverhältnissen, für die üblicherweise eine "Punktrechnung" notwendig ist, kann wegen der Logarithmusbildung durch eine "Strichrechnung" nachgebildet werden. Dies verringert den Hardware- und Software-Aufwand bei der Vergleichsoperation.
d) Es kann eine kostensparende Umsetzung der Auswertung entweder durch eine kleinere Logik und/oder CPU-zeitsparende Realisierung in einem Controller erfolgen.

## Patentansprüche

1. Verfahren zur Erlangung eines Hinweises auf eine mögliche fehlerhafte Lastbedingung eines mehrphasigen Elektromotors mit elektrischer Kommutierung mit einer elektrischen Ansteuerung, die pro Motorphase einen Highside-Schalter und einen Lowside-Schalter aufweist, wobei die Highside- und die Lowside-Schalter der Motorphasen zyklisch ein- und ausgeschaltet werden, und zwar gemäß einem Schaltschema, das zyklisch wiederkehrende Zeitpunkte aufweist, in denen für zu mindestens eine Motorphase sowohl der Highside- als auch der Lowside-Schalter für ein Ausschaltintervall hochohmig geschaltet, d.h. ausgeschaltet sind, wobei bei fehlerfreier Lastbedingung zumindest zu Beginn einzelner Ausschaltintervalle oder auch über mehrere Ausschaltintervalle hinweg noch für eine gewisse Rezirkulationszeitspanne, die gleich einem für einen fehlerfreien Betrieb des Elektromotors geltenden Erwartungswert ist, ein Strom fließt, **dadurch gekennzeichnet, dass** bei dem Verfahren
- mit Beginn eines im Schaltschema vorgegebenen Ausschaltintervalls eine Zeitmesseinheit gestartet und die Rezirkulationszeitspanne gemessen wird, bis zu der in der abgeschalteten Motorphase noch ein Strom einer Größe fließt, deren vorzeichenunabhängiger Betrag größer ist als ein vorgegebener Schwellwert,
- wobei diese Zeitmessung, sofern die Rezirkulationszeitspanne nicht während des besagten Ausschaltintervalls beendet wird, dann im zumindest nächsten Ausschaltintervall weitergeführt wird, bis die Rezirkulationszeitspanne beendet ist,
- wobei dieser Vorgang für Ausschaltintervalle nach vorheriger Highside-Schalter-Aktivierung und/oder nach vorheriger Lowside-Schalter-Aktivierung jeder Motorphase wiederholt wird,
- wobei die gemessenen Rezirkulationszeitspannen für die verschiedenen Motorphasen untereinander und/oder für jeweils eine Motorphase in sequentieller Abfolge miteinander und/oder mit dem Erwartungswert oder einem Erwartungswertbereich verglichen werden und
- wobei eine Abweichung von dem jeweiligen Erwartungswert als ein Hinweis auf das Vorliegen eines Fehlerstroms gewertet wird.

2. Verfahren nach Anspruch 1, **dadurch gekennzeichnet, dass** aus der Art der Abweichungen von den Erwartungswerten für die einzelnen Motorphasen untereinander auf die Art der fehlerhaften Lastbedingung wie Nebenschluss Motorphase gegen Motorphase, Nebenschluss Motorphase gegen Masse, Nebenschluss Motorphase gegen Versorgungsspannung, zu hochohmiger Motorphasenanschluss, Wackelkontakt einer Motorphase, fehlerhafte Widerstände einzelner Highside- oder Lowside-Schalter und/oder auch für jede einzelne Motorphase in sequentieller Abfolge auf fehlerhafte Lastbedingungen wie Wackelkontakt, mechanische Fehler, Lagerspiel, Getriebefehler, mechanische Fehler in der Applikation geschlossen wird, wobei die Häufigkeit der sequentiell auftretenden Abweichungen Aussage geben kann über den genauen Fehlerort.

3. Verfahren nach Anspruch 1 oder 2, **dadurch gekennzeichnet, dass** anstelle der Größe eines Stroms ein die Größe des Stroms repräsentierender elektrischer Parameter gemessen wird, und zwar z.B. ein Spannungsabfall über einem elektrischen/elektronischen Bauteil, insbesondere über einem Shunt-Widerstand oder über einem Transistor, bei dem es sich insbesondere um einen Highside- und/oder einen Lowside-Schalter handelt.

4. Verfahren nach einem der Ansprüche 1 bis 3, **dadurch gekennzeichnet**, die Zeitmessung in einem Ausschaltintervall durch einen Komparator beendet wird, wenn die Spannung der Motorphase eine eingestellte Komparatorschwelle über- oder unterschreitet.

5. Verfahren nach Anspruch 4, **dadurch gekennzeichnet, dass** auf ein Ausschaltintervall ein vorgegebener, dem Rezirkulationsstrom entgegengesetzter Prüfstrom aufgeschaltet wird, demzufolge der Spannungs-Wechsel am Phasenanschluss bei Reduktion des Rezirkulationsstromes auf den eingestellten Prüfstrom erfolgt.

6. Verfahren nach einem der Ansprüche 1 bis 4, **dadurch gekennzeichnet, dass** die Zeitmesseinheit linear, also mit gleichbleibender Zählgeschwindigkeit arbeitet.

7. Verfahren nach einem der Ansprüche 1 bis 4, **dadurch gekennzeichnet, dass** die Zeitmesseinheit logarithmisch arbeitet.

8. Verfahren nach einem der Ansprüche 1 bis 7, **dadurch gekennzeichnet, dass** die Zeitmessung für die Dauer zwischen den einzelnen Ausschaltintervallen angehalten wird.

9. Verfahren nach einem der Ansprüche 1 bis 7, **dadurch gekennzeichnet, dass** die Zeitmessung zwischen den einzelnen Ausschaltintervallen weiterläuft.

10. Verfahren nach einem der Ansprüche 1 bis 8, **dadurch gekennzeichnet, dass** anstelle der beschriebenen exakten Zeitmessung lediglich zu einem festen Zeitpunkt nach Beginn eines Ausschaltintervalls eine Überprüfung auf Über- oder Unterschreitung der vorgebbaren Komparatorschwelle erfolgt und demzufolge die Zeitmessung in der dadurch entstehenden Auflösung erfolgt.

11. Verfahren nach einem der Ansprüche 1 bis 9, **dadurch gekennzeichnet, dass** anstelle der Zeitspannen zwischen den jeweils besagten Mess-Start-Zeitpunkten im Schaltschema und der Einnahme der Stromschwellwerte, die Zeitspannen zwischen den einzelnen Über- und/oder Unterschreitungen der Komparator-Schwellwerte gemessen und die Zeitspannen der einzelnen Motorphasen untereinander und/oder jeder Motorphase für sich in zeitlicher Abfolge verglichen oder mit einem für den fehlerfreien Betrieb des Elektromotors geltenden Erwartungswert verglichen werden, wobei eine Abweichung der Größe der aktuellen Zeitspannen untereinander und/oder von dem Erwartungswert als ein Hinweis auf das Vorliegen eines Fehlerstroms gewertet wird.

12. Verfahren nach einem der Ansprüche 1 bis 11, **dadurch gekennzeichnet, dass** die Erwartungswerte für maximal zulässige Abweichungen, bei denen noch kein fehlerhafter Lastzustand erkannt werden soll, an mindestens einem vorgealterten Referenzsystem mit fehlerfreiem Lastzustand angelernt werden, also die typischen Werte ermittelt und mit wählbaren zusätzlichen zulässigen Toleranzen versehen in der Ansteuereinheit als maximal zulässiger Erwartungswert abgelegt werden.

13. Verfahren nach einem der Ansprüche 1 bis 11, **dadurch gekennzeichnet, dass** die Erwartungswerte für maximal zulässige Abweichungen bei denen noch kein fehlerhafter Lastzustand erkannt werden soll, an jedem Motorsystem für sich nach der Produktion mit fehlerfreiem Lastzustand angelernt werden, also die typischen Werte ermittelt und mit wählbaren zusätzlichen zulässigen Toleranzen versehen in der Ansteuereinheit als maximal zulässiger Erwartungswert abgelegt werden.

14. Verfahren nach einem der Ansprüche 1 bis 13, **dadurch gekennzeichnet, dass** die Erwartungswerte für maximal zulässige Abweichungen bei denen noch kein fehlerhafter Lastzustand erkannt werden soll, im Laufe der Lebenszeit des Motors mit höheren Toleranzen versehen werden.

15. Verfahren nach einem der Ansprüche 1 bis 14, **dadurch gekennzeichnet, dass** in dem Fall, dass die detektierte fehlerhafte Lastbedingung durch ein Abweichen des Kommutierungswinkels vom Zielbereich entsteht, die Ansteuereinheit alsdann den Fehler durch Anpassung zumindest eines der beiden Ansteuerparameter Amplitude und Phase kompensiert.

## Claims

1. A method for obtaining an indication of a possible faulty load condition of a multi-phase electric motor with electric commutation and electric drive control which, per motor phase, comprises a high-side switch and a low-side switch, wherein the high-side and low-side switches of the motor phases are cyclically switched on and off according to a switching scheme having cyclically recurring time points at which, for at least one motor phase, the high-side and the low-side switch are switched to high impedance for a switch-off interval, i.e. are switched off, wherein, without a faulty load condition, at least at the beginning of individual switch-off intervals or across several switch-off intervals, a current still flows for a certain recirculation time interval which is equal to an expectation value valid for fault-free operation of the electric motor, **characterized in that** in this method
- at the start of a switch-off interval predetermined in the switching scheme, a time measuring unit is started and the recirculation time interval is measured up to which a current of a magnitude whose sign-independent amount is greater than a predetermined threshold value still flows in the motor phase which has been switched off,
- wherein said time measurement, if the recirculation time interval is not terminated during said turn-off interval, is then continued in at least the next turn-off interval until the recirculation time interval is terminated,
- wherein this process is repeated for switch-off intervals after previous high-side switch activation and/or after previous low-side switch activation of each motor phase,
- wherein the measured recirculation time intervals for the different motor phases are compared among each other and/or for respectively one motor phase in sequential order with each other and/or with the expectation value or an expectation value range, and
- wherein a deviation from the respective expectation value is evaluated as being an indication of the existence of a faulty current.

2. The method according to claim 1, **characterized in that**, from the type of the deviations from the expectation values for the individual motor phases among each other, conclusions are drawn on the type of the faulty load condition such as e.g. shunt of motor phase toward motor phase, shunt of motor phase toward ground, shunt of motor phase toward supply voltage, too high-ohmic motor phase connection, loose contact of a motor phase, faulty resistances of individual high-side or low-side switches, and/or conclusions are drawn, also for each individual motor phase in sequential order, on faulty load conditions such as e.g. a loose contact, a mechanical defect, play of a bearing, malfunction in the transmission, or a mechanical error in the application, wherein the frequency of the sequentially occurring deviations can allow for a conclusion on the exact site of the malfunction.

3. The method according to claim 1 or 2, **characterized in that**, instead of the magnitude of a current, there is measured an electrical parameter representing the magnitude of the current, e.g. a voltage drop across an electric/electronic component, particularly across a shunt resistor or a transistor which particularly is a high-side and/or a low-side switch.

4. The method according to any one of claims 1 to 3, **characterized in that** the time measurement in a switch-off interval is terminated by a comparator when the voltage of the motor phase exceeds or falls short of a set comparator threshold.

5. The method according to claim 4, **characterized in that** a predetermined test current opposite to the recirculation current is applied to a switch-off interval, according to which the voltage change at the phase connection takes place when the recirculation current is reduced to the set test current.

6. The method according to any one of claims 1 to 4, **characterized in that** the time measuring unit operates linearly, i.e. with a constant counting speed.

7. The method according to any one of claims 1 to 4, **characterized in that** the time measuring unit operated logarithmically.

8. The method according to any one of claims 1 to 7, **characterized in that** the time measurement is stopped for the duration between the individual switch-off intervals.

9. The method according to any one of claims 1 to 7, **characterized in that** the time measurement is continued between the individual switch-off intervals.

10. The method according to any one of claims 1 to 8, **characterized in that**, instead of the described exact time measurement, there is performed, merely at a fixed time point after the start of a switch-off interval, an examination for an exceeding or falling-short of the presettable comparator threshold value and, in accordance therewith, the time measurement is performed in the thus generated resolution.

11. The method according to any one of claims 1 to 9, **characterized in that**, instead of the time intervals respectively between said measurement start time points in the switching scheme and the reaching of the current threshold value, the time intervals between the individual exceeding or falling-short of the comparator threshold values are measured and the time intervals of the individual motor phases among each other and/or of each motor phase for itself are compared in temporal succession or are compared to an expectation value valid for fault-free operation of the electric motor, wherein a deviation of the amount of the current time intervals among each other and/or from the expectation value is evaluated as being an indication of the existence of a faulty current.

12. The method according to any one of claims 1 to 11, **characterized in that** the expectation values for maximally allowable deviations where it is not yet desired that a faulty load condition is detected, are obtained, by training, on at least one pre-aged reference systems with fault-free load condition, i.e. the typical values are detected and, provided with selectable additional allowable tolerances, are deposited in the drive unit as a maximum allowable expectation value.

13. The method according to any one of claims 1 to 11, **characterized in that** the expectation values for maximally allowable deviations where it is not yet desired that a faulty load condition is detected, are - after production - obtained, by training, on each motor system for itself with fault-free load condition, i.e. the typical values are detected and, provided with selectable additional allowable tolerances, are deposited in the drive unit as a maximum allowable expectation value.

14. The method according to any one of claims 1 to 13, **characterized in that** the expectation values for maximally allowable deviations where it is not yet desired that a faulty load condition is detected, are, in the course of the lifetime of the motor, provided with higher tolerances.

15. The method according to any one of claims 1 to 14, **characterized in that**, in case that the detected faulty load condition is generated by deviation of the commutation angle from the target range, the drive unit then compensates for the error by adaptation of at least one of the two drive parameters "amplitude" and "phase".

## Revendications

1. Procédé d'obtention d'une indication sur une condition de charge potentiellement erronée d'un moteur électrique multiphasé à commutation électrique dotée d'une commande électrique, laquelle comporte un commutateur côté alimentation et un commutateur côté masse par phase moteur, dans lequel les commutateurs côté alimentation et côté masse des phases moteur sont mis en marche et arrêtés de manière cyclique, à savoir conformément à un schéma de commutation, lequel comporte des instants répétés de manière cyclique où pour au moins une phase moteur aussi bien le commutateur côté alimentation que côté masse sont commutés à une valeur ohmique élevée, c'est-à-dire arrêtés, pendant un intervalle d'arrêt, dans lequel, en cas de condition de charge non erronée, un courant circule encore au moins au début de certains intervalles d'arrêt ou également sur plusieurs intervalles d'arrêt pendant une certaine période de recirculation qui est égale à une valeur attendue valable pour un fonctionnement non erroné du moteur électrique, **caractérisé en ce que**, lors du procédé une unité de mesure du temps est démarrée avec le début d'un intervalle d'arrêt prédéfini dans le schéma de commutation et la période de recirculation est mesurée, jusqu'à ce qu'un courant d'une grandeur dont la valeur absolue est supérieure à une valeur seuil prédéfinie circule encore dans la phase moteur coupée,
- dans lequel cette mesure du temps, pour autant que la période de recirculation ne se termine pas pendant ledit intervalle d'arrêt, est poursuivie au moins dans l'intervalle d'arrêt suivant, jusqu'à ce que la période de recirculation se termine,
- dans lequel cette opération est répétée pour les intervalles d'arrêt après l'activation du commutateur côté alimentation et/ou après l'activation du commutateur côté masse de chaque phase moteur,
- dans lequel les périodes de recirculation pour les différentes phases moteur sont comparées les unes par rapport aux autres et/ou l'une par rapport à l'autre pour une phase moteur respective en ordre séquentiel et/ou par rapport à une valeur attendue ou un intervalle de valeurs attendues et
- dans lequel une déviation par rapport à la valeur attendue respective est jugée comme une indication sur la présence d'un courant d'erreur.

2. Procédé selon la revendication 1, **caractérisé en ce qu'**à partir du type des déviations depuis les intervalles de valeurs attendues, le type de condition de charge erronée telle que dérivation phase moteur à phase moteur, dérivation phase moteur à masse, dérivation phase moteur à tension d'alimentation, connexion de phase moteur ayant une résistivité trop élevée, mauvais contact d'une phase moteur, résistances erronées de commutateurs individuels côté alimentation ou côté masse peut être déduit pour les phases moteur individuelles les unes par rapport aux autres et/ou les conditions de charge erronées telles que mauvais contact, défaut mécanique, jeu de palier, défaut de transmission, défaut mécanique dans l'application peuvent être également déduites pour chaque phase moteur individuelle en ordre séquentiel, dans lequel la fréquence des déviations se produisant de façon séquentielle peut donner une indication sur le lieu exact de l'erreur.

3. Procédé selon la revendication 1 ou 2, **caractérisé en ce qu'**à la place de la grandeur d'un courant, un paramètre électrique représentant la grandeur du courant est mesuré, à savoir par exemple une chute de tension aux bornes d'un composant électrique/électronique, en particulier aux bornes d'une résistance de shunt ou d'un transistor, où il s'agit en particulier d'un commutateur côté alimentation et/ou d'un commutateur côté masse.

4. Procédé selon l'une des revendications 1 à 3, **caractérisé en ce que** la mesure du temps dans un intervalle d'arrêt est terminée par un comparateur lorsque la tension de la phase moteur dépasse ou sous-dépasse un seuil de comparateur configuré.

5. Procédé selon la revendication 4, **caractérisé en ce qu'**un courant d'essai prédéterminé, opposé au courant de recirculation, est appliqué sur un intervalle d'arrêt, par conséquent le changement de tension au niveau du raccordement de phase s'effectue lors de la réduction du courant de recirculation au courant d'essai configuré.

6. Procédé selon l'une des revendications 1 à 4, **caractérisé en ce que** l'unité de mesure du temps fonctionne de manière linéaire, c'est-à-dire avec une vitesse de comptage constante.

7. Procédé selon l'une des revendications 1 à 4, **caractérisé en ce que** l'unité de mesure du temps fonctionne de manière logarithmique.

8. Procédé selon l'une des revendications 1 à 7, **caractérisé en ce que** la mesure du temps s'interrompt entre les intervalles d'arrêt individuels.

9. Procédé selon l'une des revendications 1 à 7, **caractérisé en ce que** la mesure du temps se poursuit entre les intervalles d'arrêt individuels.

10. Procédé selon l'une des revendications 1 à 8, **caractérisé en ce qu'**à la place de la mesure du temps exacte décrite, un contrôle de dépassement ou sous-dépassement du seuil de comparateur pouvant être prédéfini s'effectue uniquement jusqu'à un instant fixe après le début d'un intervalle d'arrêt et par conséquent la mesure du temps s'effectue dans la résolution qui en découle.

11. Procédé selon l'une des revendications 1 à 9, **caractérisé en ce qu'**à la place des périodes entre les instants de début de mesure respectifs dans le schéma de commutation et l'occupation des valeurs seuil de courant, les instants entre les dépassements et/ou sous-dépassements des valeurs seuil de comparateur sont mesurées et les périodes des phases moteur individuelles sont comparées l'une par rapport à l'autre et/ou les périodes de chaque phase moteur sont comparées séparément en ordre chronologique ou sont comparées à une valeur attendue valable pour le fonctionnement non erroné du moteur électrique, dans lequel une déviation de la grandeur des périodes actuelles les unes par rapport aux autres et/ou par rapport à la valeur attendue est jugée comme une indication sur la présence d'un courant d'erreur.

12. Procédé selon l'une des revendications 1 à 11, **caractérisé en ce que** les valeurs attendues pour les déviations maximales autorisées, pour lesquelles aucun état de charge erroné ne doit être reconnu, sont apprises avec état de charge non erroné sur au moins un système de référence pré-vieilli, les valeurs typiques sont donc calculées et sont déposées dans l'unité de commande en tant que valeurs attendues maximales autorisées prévues avec des tolérances autorisées supplémentaires sélectionnables.

13. Procédé selon l'une des revendications 1 à 11, **caractérisé en ce que** les valeurs attendues pour les déviations maximales autorisées, pour lesquelles aucun état de charge erroné ne doit être reconnu, sont apprises avec état de charge non erroné séparément sur chaque système moteur après la production, les valeurs typiques sont donc calculées et sont déposées dans l'unité de commande en tant que valeurs attendues maximales autorisées prévues avec des tolérances autorisées supplémentaires sélectionnables.

14. Procédé selon l'une des revendications 1 à 13, **caractérisé en ce que** les valeurs attendues pour les déviations maximales autorisées, pour lesquelles aucun état de charge erroné ne doit être reconnu, sont prévues avec des tolérances plus élevées au cours de la vie du moteur.

15. Procédé selon l'une des revendications 1 à 14, **caractérisé en ce que** dans le cas où la condition de charge défectueuse détectée apparaît par une déviation de l'angle de commutation par rapport à l'intervalle cible, l'unité de commande compense alors le défaut par adaptation d'au moins un deux paramètres d'amorçage (amplitude et phase).
